(19) Europäisches Patentamt

**European Patent Office**

**Office européen des brevets**

(11) Numéro de publication : **0 019 499 B1**

(12) **FASCICULE DE BREVET EUROPÉEN**

(45) Date de publication du fascicule du brevet : **16.11.83**

(51) Int. Cl.³ : **H 05 K 7/02**, H 05 K 3/36, H 04 N 5/64

(21) Numéro de dépôt : **80400501.5**

(22) Date de dépôt : **15.04.80**

(54) **Procédé de fabrication d'un châssis support pour circuits imprimés plus particulièrement utilisé dans un récepteur de télévision.**

(30) Priorité : **18.05.79 FR 7912710**

(43) Date de publication de la demande : **26.11.80 Bulletin 80/24**

(45) Mention de la délivrance du brevet : **16.11.83 Bulletin 83/46**

(84) Etats contractants désignés : **BE DE GB IT NL**

(56) Documents cités :
**FR A 1 239 226**
**FR A 1 340 640**
**FR A 1 446 396**
**US A 3 780 431**
**US A 3 914 547**
**US A 4 002 398**

(73) Titulaire : **THOMSON-BRANDT**
**173, Boulevard Haussmann**
**F-75379 Paris Cedex 08 (FR)**

(72) Inventeur : **Bleynie, Jean-Marie**
**"THOMSON-CSF" - SCPI - 173, Bld Haussmann**
**F-75360 Paris Cedex 08 (FR)**
Inventeur : **Narbonne, Claude**
**"THOMSON-CSF" - SCPI - 173, Bld Haussmann**
**F-75360 Paris Cedex 08 (FR)**
Inventeur : **Pataillot, Georges**
**"THOMSON-CSF" - SCPI - 173, Bld Haussmann**
**F-75360 Paris Cedex 08 (FR)**

(74) Mandataire : **Thierr, Françoise et al**
**THOMSON-CSF SCPI 173, Bld Haussmann**
**F-75379 Paris Cedex 08 (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Procédé de fabrication d'un châssis support pour circuits imprimés plus particulièrement utilisé dans un récepteur de télévision

La présente invention concerne un procédé de fabrication de châssis supportant des circuits imprimés plus particulièrement associés à un tube cathodique de visualisation utilisé dans les récepteurs de télévision.

Un récepteur de télévision comporte de nombreux circuits électroniques, chacun d'eux correspondant à un dispositif dont la fonction est bien définie. En général ces circuits sont regroupés sur des circuits imprimés dont le nombre, bien que limité, peut par exemple être de l'ordre d'une dizaine, et donc reste important.

Chacun de ces circuits nécessite une opération de gravure, une opération de fixation des composants électriques et électroniques et de soudure des connexions de ces composants, un test de bon fonctionnement et le montage du circuit sur le châssis métallique du récepteur de télévision ou directement sur un autre circuit.

Dans les chaînes de montage actuelles, ces opérations sont presque entièrement automatiques. Cette automatisation nécessite par contre un nombre important de machines-outils ; par exemple, pour l'opération d'insertion des composants électroniques sur les circuits imprimés, la chaîne de montage peut comporter autant de machines-outils qu'il y a de circuits imprimés différents ; une même machine peut également être utilisée pour l'ensemble des différents circuits, mais avec des temps d'arrêt à prévoir pour effectuer un réglage de la machine-outil lorsque l'on passe d'un type de circuit imprimé à un autre. Ces temps d'arrêt peuvent être importants et ainsi augmenter très sensiblement le coût de production.

De plus, chaque type de récepteur de télévision ayant son esthétique particulière, la disposition des circuits imprimés et la forme du châssis métallique change, obligeant à nouveau une réadaptation complète de la chaîne de production à chaque changement de forme du récepteur de télévision.

Enfin chaque circuit imprimé est testé séparément, ce qui ne garantit pas le bon fonctionnement du récepteur de télévision lorsque l'ensemble des différents circuits imprimés sont interconnectés.

Le procédé selon l'invention vise à remédier à ces inconvénients.

Selon l'invention, le procédé de fabrication d'un châssis se caractérise par le fait qu'il comporte la combinaison des quatre étapes suivantes :

— une première étape dans laquelle le châssis est soit prédécoupé dans une plaque d'un matériau quelconque supportant un pliage, soit obtenu par coulage de ce même matériau dans un moule ;

— une seconde étape, dans laquelle un unique circuit imprimé prégravé et comportant des lignes de moindre résistance est fixé rigidement à l'aide de moyens de fixation sur le châssis ;

— une troisième étape, dans laquelle les composants électroniques, les prises de branchement et les liaisons diverses sont insérés et soudés sur cet unique circuit imprimé et les composants spéciaux sont fixés sur le châssis dans des logements prévus lors de la découpe ou du coulage du châssis ;

— une quatrième étape, dans laquelle le châssis est mis en forme, provoquant la rupture du circuit imprimé selon les lignes préétablies de moindre résistance, cette rupture conservant une liaison électrique entre les différents fragments du circuit imprimé, ces liaisons électriques jouant également le rôle de liaison mécanique souple pour les fragments du circuit imprimé devenus libres de tous autres liens.

Il est vrai qu'une partie des étapes du procédé ainsi défini est connue par le brevet US 3 780 431 qui vise la fabrication de plusieurs plaquettes de circuit imprimé à partir d'une unique plaque de circuit imprimé. Mais le procédé selon l'invention faisant appel, notamment, à un châssis prédécoupé ou moulé et conservant une liaison électrique entre les diverses plaquettes de circuit imprimé, permet un gain de temps appréciable pour la fabrication de châssis supports de circuits imprimés, tels que ceux des récepteurs de télévision.

D'autres avantages et caractéristiques de l'invention apparaîtront dans la description qui suit, donnée à l'aide des figures qui représentent :

la figure 1, un exemple de forme du châssis après découpage ;

les figures 2a et 2b, deux exemples de stockage des châssis comportant le circuit imprimé câblé ;

la figure 3, un exemple de châssis terminé et monté sur un tube cathodique de récepteur de télévision.

Dans la description de l'exemple non limitatif qui suit le châssis est supposé métallique et obtenu par découpage dans une plaque de métal.

Le procédé de fabrication de ce châssis métallique supportant des circuits imprimés suivant l'invention comporte, comme cela a été dit déjà, plusieurs étapes.

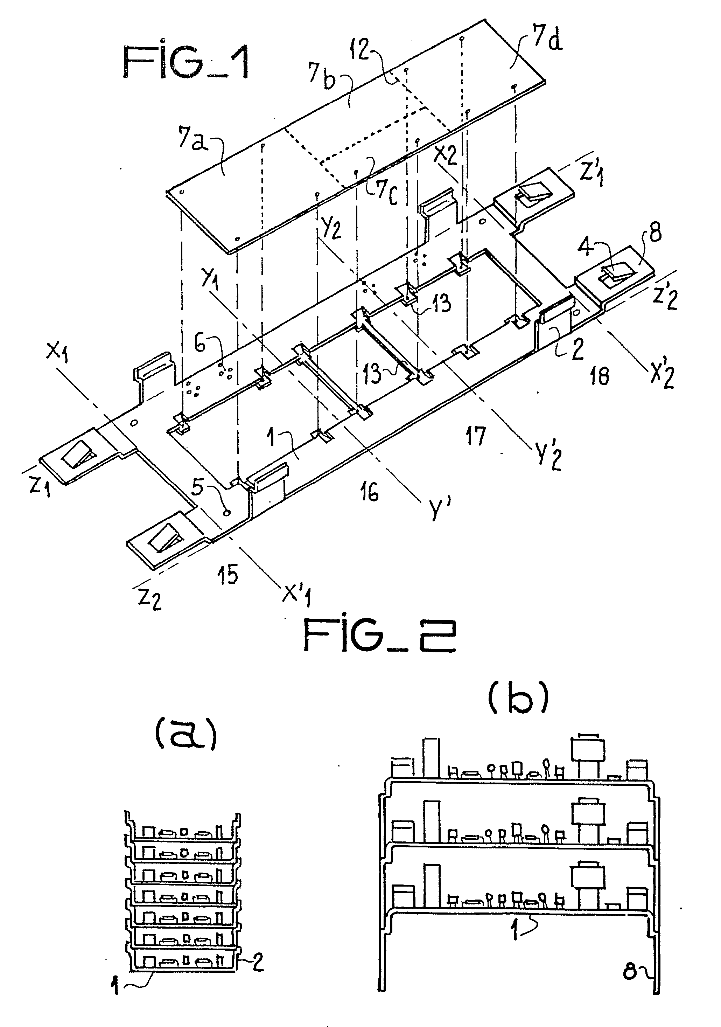

La première comprend principalement d'une part la gravure de l'unique circuit imprimé utilisé regroupant l'ensemble des dispositifs électroniques nécessaires à la réalisation du récepteur de télévision, et d'autre part, le découpage du châssis métallique dans une plaque de métal plane. La figure 1 montre un exemple de réalisation d'un châssis métallique et du circuit imprimé associé. Le châssis métallique 1 découpé comporte un ensemble de pattes 2 et 8 se trouvant sur les côtés et sur les extrémités du châssis métallique 1 proprement dit. Ces pattes 2 et 8, ou du moins certaines d'entre elles, sont après découpage du châssis métallique 1 dans la plaque de métal plane, pliées suivant un certain profil autorisant un empilage des châssis métalliques 1 et aménageant entre deux châssis métalliques 1 successifs un espace vide évitant que les composants sur le circuit imprimé soient détériorés par le châssis voisin.

Les pattes 8 correspondant aux extrémités du châssis métallique 1 sont spécialement découpées de façon à posséder des moyens 4 permettant une fixation ultérieure du châssis métallique 1 sur le tube cathodique ou sur l'ébénisterie d'un récepteur de télévision.

Ces moyens de fixation 4 peuvent être par exemple des pattes secondaires ou des fentes, pratiquées dans les pattes principales 8 de façon à permettre un cerclage efficace autour du tube cathodique.

L'opération de découpage du châssis métallique 1 a également pour résulat de constituer des moyens 13 de fixation du circuit imprimé 7 en plusieurs endroits du châssis métallique 1, ces endroits étant déterminés par la nécessité de conserver après rupture du circuit imprimé 7 certains fragments de ce circuit imprimé 7 fixés rigidement sur le châssis métallique 1.

Des trous 5 sont également pratiqués dans le châssis métallique 1, de façon à permettre dans les opérations ultérieures de fabrication un guidage des châssis métalliques 1 par empilage sur des tiges et/ou leur entraînement sur les chaînes de montage, par exemple entre deux étapes de la fabrication.

Enfin des logements 6 de formes adaptées sont ménagés dans le châssis métallique 1 pour les composants spéciaux comme par exemple les transistors de puissance permettant ainsi l'utilisation de ce châssis comme radiateur thermique, et une fixation plus rigide.

Parallèlement à ce découpage du châssis métallique 1, l'unique circuit imprimé 7 est gravé et perforé en fonction des circuits qu'il est amené à supporter. Des perforations supplémentaires à des distances régulières les unes des autres et selon des lignes prédéterminées 12, pouvant par exemple être des segments de droite, sont également pratiquées dans ce circuit imprimé 7 ; celles-ci ont pour but de créer des lignes de moindre résistance telles que, au cours d'un pliage de ce circuit imprimé, celui-ci ne puisse se casser que suivant ces lignes 12 prédéterminées. On peut également arriver à ce résultat en remplaçant la perforation en pointillé par une fente de profondeur convenable pratiquée sur l'une ou les deux faces du circuit imprimé 7, chaque fente ou couple de fentes, qui sont alors symétriques par rapport au plan de symétrie du circuit imprimé 7, déterminant une ligne de moindre résistance 12.

Une seconde étape de ce procédé de fabrication d'un châssis métallique 1 servant de support à un circuit imprimé 7, consiste en l'insertion des différents composants sur ce circuit imprimé 7 fixé rigidement sur le châssis métallique 1 ; ce sont les divers composants électroniques, les prises de branchement devant permettre d'assurer, en fonctionnement, par exemple l'alimentation en énergie électrique, ou le raccordement d'accessoires divers. Ce sont également les connexions souples destinées à relier électriquement les fragments (7a, 7b, 7c, 7d) du circuit imprimé 7 après rupture au niveau des lignes 12 de moindre résistance ; ces connexions souples qui peuvent être constituées de fils électriques ou de circuits imprimés souples assurent également, après la cassure du circuit imprimé 7, un lien mécanique entre les fragments libres et ceux fixés rigidement sur le châssis métallique 1. A cette étape sont également insérés les composants spéciaux dans les logements spéciaux 6 élaborés au cours de la première étape du procédé de fabrication au moment du découpage du châssis métallique 1. Ensuite dans une troisième étape les composants du circuit imprimé 7 sont soudés par exemple selon la technique connue de la soudure à la vague. Cette opération peut également être utilisée pour souder le circuit imprimé 7 sur le châssis métallique 1 à l'aide des moyens de fixation 13 qui peuvent être alors simplement constitués par des pattes métalliques.

Les figures 2a et 2b montrent deux exemples de stockage du châssis métallique à la fin de cette troisième étape. La figure 2a montre un stockage par empilage en se servant des pattes latérales 2 du châssis métallique 1, ces pattes 2 étant repliées vers la face du circuit imprimé 7 supportant les composants électroniques, d'un angle de 90° ; la figure 2b montre un stockage par empilage en se servant des pattes 8 se trouvant aux extrémités du châssis métallique 1, ces pattes 8 étant repliées d'un angle de 90° vers la face du circuit imprimé 7 comportant les soudures.

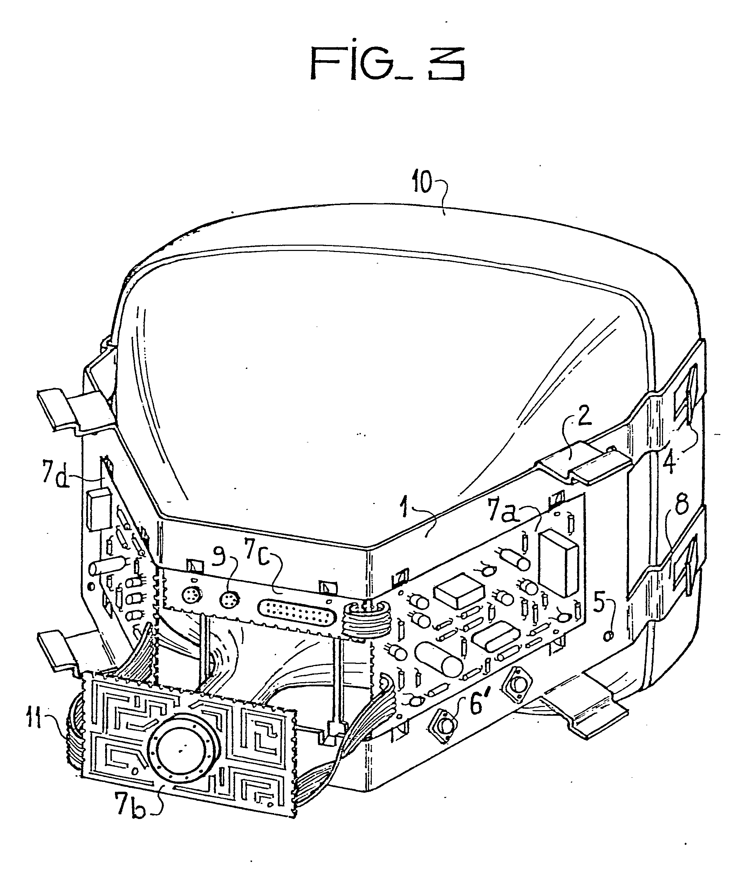

Une quatrième étape de ce procédé de fabrication consiste en la mise en forme du châssis métallique 1. Le résultat de cette mise en forme, pour l'exemple du châssis métallique 1 et du circuit imprimé 7 de la figure 1, est donné sur la figure 3. Le châssis métallique 1 est alors plié par exemple selon quatre axes parallèles $x_1x_1'$, $x_2x_2'$, $y_1y_1'$, et $y_2y_2'$ de façon à obtenir une forme du châssis métallique 1 la plus proche possible du contour extérieur de la pièce sur laquelle il est monté, par exemple un tube cathodique d'un récepteur de télévision. Cette forme de pliage permet ainsi d'obtenir un encombrement supplémentaire minimum par rapport à l'encombrement initial par exemple du tube cathodique 10. Ce pliage a également pour effet de casser le circuit imprimé 7 par exemple en quatre morceaux (7a, 7b, 7c, 7d) délimités par les lignes 12 de moindre résistance. Les connexions souples 11 reliant ces circuits permettent alors de conserver les liaisons électriques, ainsi que des liens mécaniques ; en effet, dans l'exemple montré ici sur la figure 3, le fragment du circuit imprimé 7b devant se fixer directement sur le tube cathodique 10, il devient après cassure, libre du châssis métallique 1 et des autres fragments du circuit imprimé 7, et n'est donc plus retenu que par les connexions souples 11 permettant également un raccordement plus aisé au tube cathodique 10. Cette disposition permet en outre d'éviter les liaisons électriques entre les différents châssis de l'art antérieur qui, le plus souvent, étaient fixées sur l'ébénisterie du récepteur de télévision d'où une difficulté de câblage et éventuellement de dépannage, cette opération de dépannage devant se faire le tube cathodique 10 monté dans l'ébénisterie. Les pattes latérales 2 ne seront dans cette étape modifiées en position, que si elles gênent d'autres pièces extérieures à celles considérées dans cette description comme par exemple le capot arrière du récepteur de télévision ; par contre, les pattes 8 correspondant aux extrémités du châssis métallique 1, seront orientées de façon à permettre une fixation aisée au tube cathodique 10 sur lequel le châssis métallique 1 est par exemple monté. On peut alors, dans un mode préférentiel, mais non limitatif, mettre en forme les pattes extérieures 8 soit dès la première étape soit pendant la mise en forme du châssis métallique 1, de façon à ce qu'elles soient ajustées au contour de l'écran du tube cathodique 10, permettant ainsi un cerclage en utilisant les pattes secondaires 4 pour maintenir le cerclage en place.

L'ensemble des étapes précédentes peut être fait de façon automatique par des machines-outils.

La dernière étape consiste alors à relier manuellement certains composants spéciaux 6' dont l'automatisation est délicate, et à raccorder le châssis aux organes de commande par exemple du panneau avant du récepteur de télévision, à l'aide des prises de branchement 9 prévues sur certains fragments du circuit imprimé 7.

Un avantage supplémentaire de ce procédé est de n'insérer l'ensemble des circuits électroniques dans l'ébénisterie qu'à l'étape ultime.

Un autre avantage est de pouvoir adapter ces châssis à un format quelconque de tube cathodique, seul changeant alors le dispositif de fixation que l'on doit prévoir soit sur l'ébénisterie soit sur le tube cathodique par un dispositif non décrit ici qui doit être adapté aux pattes extérieures 8 ou latérales 2.

Pour certaines dispositions de lignes 12 de moindre résistance sur le circuit imprimé 7, il pourra s'avérer nécessaire de prévoir parallèlement aux opérations de pliage du châssis métallique 1, l'application de contrainte mécanique, par exemple par torsion, sur certaines parties du circuit imprimé 7 afin de permettre une rupture de ce circuit imprimé 7 au niveau de chaque ligne 12 de moindre résistance.

Dans une variante de ce procédé de fabrication, les deuxième et troisième étapes peuvent être permutées ; on peut en effet procéder au câblage du circuit imprimé 7 avant sa fixation sur le châssis 1.

Le châssis support 1 peut être en une matière quelconque autre que le métal permettant les différentes étapes de fabrication décrites précédemment. Dans le cas où ce matériau est par exemple du type matière plastique, polyéthylène ou autre, des radiateurs thermiques supplémentaires sont fixés sur ce châssis 1 au cours de l'une des étapes de fabrication.

Enfin ce châssis support 1 peut être obtenu soit par découpage d'une plaque d'un matériau déterminé, soit par coulage dans un moule ayant la forme désirée.

On a ainsi décrit un procédé de fabrication de châssis métallique servant de support à des circuits imprimés, adapté plus particulièrement aux chaînes de montage des récepteurs de télévision, ainsi qu'un récepteur de télévision le comprenant.

**Revendications**

1. Procédé de fabrication d'un chassis de support pour circuits imprimés, plus particulièrement utilisé dans un récepteur de télévision, caractérisé en ce que, ce châssis étant destiné à être fixé sur un tube cathodique, ledit procédé comporte la combinaison des quatre étapes de fabrication suivantes :

— une première étape dans laquelle le châssis (1) est soit prédécoupé dans une plaque d'un matériau quelconque supportant un pliage, soit obtenu par coulage de ce même matériau dans un moule ;

— une seconde étape, dans laquelle un unique circuit imprimé (7) prégravé et comportant des lignes de moindre résistance (12) est fixé rigidement à l'aide de moyens de fixation (13) sur le châssis (1) ;

— une troisième étape, dans laquelle les composants électroniques, les prises de branchement (9) et les liaisons diverses (11) sont insérés et soudés sur cet unique circuit imprimé (7) et les composants spéciaux (6') sont fixés sur le châssis (1) dans des logements prévus lors de la découpe ou du coulage du châssis (1) ;

— une quatrième étape, dans laquelle le châssis (1) est mis en forme, provoquant la rupture du circuit imprimé (7) selon les lignes (12) préétablies de moindre résistance, cette rupture conservant une liaison électrique entre les différents fragments du circuit imprimé (7), ces liaisons électriques jouant également le rôle de liaison mécanique souple pour les fragments du circuit imprimé (7) devenus libres de tous autres liens.

2. Procédé de fabrication d'un châssis selon la revendication 1, caractérisé en ce que dans la première étape, des trous (5) sont ménagés dans le châssis (1), ces trous servant à l'entraînement et/ou au guidage de ce châssis (1) dans les autres étapes de fabrication.

3. Procédé de fabrication d'un châssis selon la revendication 1, caractérisé en ce que dans la première étape, le découpage ou le coulage du châssis (1) ménage sur celui-ci des pattes (2) et (8) dont certaines sont repliées suivant un profil tel qu'il permette un empilage de ces châssis (1) les uns sur les autres lors du stockage, avec création d'un espace libre entre deux châssis (1) consécutifs.

4. Procédé de fabrication d'un châssis selon la revendication 3, caractérisé en ce que dans la première étape, les pattes (8) se trouvant à l'extrémité du châssis (1) sont découpées ou coulées de façon à créer des moyens (4) de fixation de ce châssis (1) sur le tube cathodique auquel il est destiné.

5. Procédé de fabrication d'un châssis selon la revendication 1, caractérisé en ce que dans la quatrième étape, le châssis (1) est plié de façon à prendre une forme restant le plus près possible du tube cathodique sur lequel il est fixé.

6. Procédé de fabrication d'un châssis selon la revendication 5, caractérisé en ce que le pliage du châssis (1) est fait selon des lignes parallèles (15, 16, 17, 18), et en ce que les pattes (8) se trouvant à l'extrémité du châssis (1) coïncident alors avec le contour de l'écran du tube cathodique ou avec des moyens de fixation extérieurs solidaires soit du tube cathodique soit de l'ébénisterie du récepteur de télévision.

7. Procédé de fabrication d'un châssis selon la revendication 1, caractérisé en ce que dans la première étape, le châssis (1) est découpé dans une plaque métallique ou dans une matière synthétique souple.

8. Procédé de fabrication d'un châssis selon la revendication 1, caractérisé en ce que dans la première étape le châssis (1) est obtenu par coulage d'un métal ou d'une matière synthétique dans un moule.

## Claims

1. Method of producing a supporting chassis for printed circuits, especially for use in a television receiver, characterized in that, the chassis being susceptible to be fixed onto a cathode ray tube, said method comprises the combination of the following four producing steps :
— a first step in which the chassis (1) is either pre-blanked from a plate of any material permitting bending thereof or by molding said material in a mold ;
— a second step in which a single printed circuit (7) which is pre-engraved and comprises lines of reduced resistance (12) is rigidly fixed onto the chassis (1) using fixing means (13) ;
— a third step in which the electronic components, the connection terminals (9) and the various connections (11) are inserted and soldered onto said single printed circuit (7) and the special components (6') are fixed to the chassis (1) within accomodations provided during the blanking or molding of the chassis (1) ;
— a fourth step in which the chassis (1) is shaped, causing the printed circuit (7) to break along the predetermined lines (12) of reduced resistance, said breaking preserving an electrical connection between the different fragments of the printed circuit (7), these electrical connections additionally forming flexible mechanical connections of the printed circuit (7) fragments freed from any other connection.

2. Method of producing a chassis in accordance with claim 1, characterized in that, in the first step, holes (5) are arranged in the chassis (1), said holes being used for moving and/or guiding said chassis (1) during the other production steps.

3. Method of producing a chassis in accordance with claim 1, characterized in that in the first step, the blanking or molding of the chassis (1) produces fingers (2) and (8) thereon certain fingers of which are folded in accordance with a profile permitting these chassis (1) to be stacked one above the other for storage, a free space being respectively formed between two successive chassis (1).

4. Method of producing a chassis in accordance with claim 3, characterized in that in the first step, the fingers (8) located at the end of the chassis (1) are cut out or molded in a manner to form means (4) for fixing said chassis (1) on the cathode ray tube to be associated therewith.

5. Method of producing a chassis in accordance with claim 1, characterized in that in the fourth step, the chassis (1) is folded in a manner to assume a shape following as closely as possible the shape of the cathode ray tube on which it is mounted.

6. Method of producing a chassis in accordance with claim 5, characterized in that the folding of the chassis (1) is performed along parallel lines (15, 16, 17, 18) and in that the fingers (8) located at the end of the chassis (1) are coincident with the contour of the screen of the cathode ray tube or with exterior fixing means joined either with the cathode ray tube or with the housing of the television receiver.

7. Method of producing a chassis in accordance with claim 1, characterized in that in the first step, the chassis (1) is blanked from a metal plate or from a flexible synthetic material.

8. Method of producing a chassis in accordance with claim 1, characterized in that in the first step, the chassis (1) is obtained by pouring a metal or a synthetic material into a mold.

## Ansprüche

1. Verfahren zur Herstellung eines Trägerchassis für gedruckte Schaltungen, das insbesondere in einem Fernsehempfänger verwendet wird, dadurch gekennzeichnet, daß dieses Verfahren die Kombination der folgenden vier Herstellungsschritte umfaßt, wobei das Chassis zur Befestigung an einer Kathodenstrahlröhre bestimmt ist :
— ein erster Schritt, bei dem das Chassis (1) entweder aus einer Platte aus beliebigem biegbaren Material vorgestanzt wird oder durch Eingießen dieses Materials in eine Form erhalten wird ;
— ein zweiter Schritt, bei dem eine einzige gedruckte Schaltung (7), die vorgraviert ist und Linien (12) verminderten Widerstands umfaßt, durch Befestigungsmittel (13) starr an dem Chassis (1) befestigt wird ;
— ein dritter Schritt, bei dem die Elektronikbauteile, die Anschlußstecker (9) und die verschiedenen Verbindungen (11) eingefügt und an dieser einzigen gedruckten Schaltung (7) festgelötet werden und die speziellen Bauteile (6') an dem Chassis (1) in Aufnahmen befestigt werden, die während des Ausstanzens bzw. Formens des Chassis (1) vorgesehen wurden ;

— ein vierter Schritt, in dem das Chassis (1) in Form gebracht wird, wobei das Brechen der gedruckten Schaltung (7) entlang den vorbestimmten Linien (12) verminderten Widerstands hervorgerufen wird, wobei während dieses Brechens eine elektrische Verbindung zwischen den verschiedenen Bruchstücken der gedruckten Schaltung (7) bewahrt wird und diese elektrischen Verbindungen überdies die Funktion einer flexiblen mechanischen Verbindung für die Bruchstücke der gedruckten Schaltung (7) erfüllen, welche von allen anderen Verbindungen frei geworden sind.

2. Verfahren zur Herstellung eines Chassis nach Anspruch 1, dadurch gekennzeichnet, daß während des ersten Schritts Löcher in dem Chassis (1) angebracht werden, die für die Mitbewegung und/oder die Führung dieses Chassis (1) bei den anderen Herstellungsschritten dienen.

3. Verfahren zur Herstellung eines Chassis nach Anspruch 1, dadurch gekennzeichnet, daß bei dem ersten Schritt das Ausstanzen oder Formen des Chassis (1) an diesem Chassis Laschen (2) und (8) bildet, von denen bestimmte gemäß einem solchen Profil umgebogen sind, daß es ein Aufeinanderstapeln dieser Chassis (1) übereinander bei der Lagerung gestattet, unter Bildung eines Freiraumes zwischen zwei aufeinanderfolgenden Chassis (1).

4. Verfahren zur Herstellung eines Chassis nach Anspruch 3, dadurch gekennzeichnet, daß in dem ersten Schritt die sich an dem Endes des Chassis (1) befindenden Laschen (8) derart ausgestanzt oder geformt werden, daß Mittel (4) zur Befestigung dieses Chassis (1) an der Kathodenstrahlröhre geschaffen werden, für die es bestimmt ist.

5. Verfahren zur Herstellung eines Chassis nach Anspruch 1, dadurch gekennzeichnet, daß in dem vierten Schritt das Chassis (1) derart gebogen wird, daß es eine Form annimmt, die der Kathodenstrahlröhre, an der es befestigt ist, möglichst nahekommt.

6. Verfahren zur Herstellung eines Chassis nach Anspruch 5, dadurch gekennzeichnet, daß das Biegen des Chassis (1) entlang parallelen Linien (15, 16, 17, 18) erfolgt und daß die Laschen (8), welche sich an dem Ende des Chassis (1) befinden, dann mit der Kontur des Schirms der Kathodenstrahlröhre oder mit äußeren Befestigungsmitteln zusammenfallen, die entweder mit der Kathodenstrahlröhre oder mit dem Gehäuse des Fernsehempfängers fest verbunden sind.

7. Verfahren zur Herstellung eines Chassis nach Anspruch 1, dadurch gekennzeichnet, daß in dem ersten Schritt das Chassis (1) aus einer Metallplatte oder aus einem nachgiebigen synthetischen Material ausgestanzt wird.

8. Verfahren zur Herstellung eines Chassis nach Anspruch 1, dadurch gekennzeichnet, daß in dem ersten Schritt das Chassis (1) durch Formen eines Metalls oder eines synthetischen Materials in einer Form gebildet wird.

0 019 499

FIG_1

FIG_2

(a)

(b)

1

# FIG_3